# EUROPEAN PATENT APPLICATION

(11) **EP 4 266 361 A1**
(43) Date of publication of application: **25.10.2023**
(21) Application number: 23158007.7
(22) Date of filing: 22.02.2023
(51) Int. Cl.: H01L 23/31, H01L 23/498, H01L 23/538

(54) **SEMICONDUCTOR PACKAGE HAVING A THICK LOGIC DIE**

(30) Priority: 03.03.2022 US 202263316004 P; 09.02.2023 US 202318107520
(71) Applicant: MediaTek Inc., Hsin-Chu 300 (TW)
(72) Inventor: YU, Ta-Jen, 30078 Hsinchu City (TW); LIN, Shih-Chin, 30078 Hsinchu City (TW); CHEN, Tai-Yu, 30078 Hsinchu City (TW); YANG, Bo-Jiun, 30078 Hsinchu City (TW); LIN, Bing-Yeh, 30078 Hsinchu City (TW); HUANG, Yung-Cheng, 30078 Hsinchu City (TW); HSU, Wen-Sung, 30078 Hsinchu City (TW); MA, Bo-Hao, 30078 Hsinchu City (TW); SONG, Isabella, 30078 Hsinchu City (TW)
(74) Representative: Hoefer & Partner Patentanwälte mbB

(57) **Abstract**

A semiconductor package (10) includes a bottom substrate (100) and a top substrate (300) space apart from the bottom substrate (100) such that the bottom substrate (100) and the top substrate (300) define a gap therebetween. A logic die (50) is mounted on a top surface (100a) of the bottom substrate (100). The logic die (50) has a thickness of 125-350 micrometers. A plurality of copper cored solder balls (60) is disposed between the bottom substrate (100) and the top substrate (300) around the logic die (50) to electrically connect the bottom substrate (100) with the top substrate (300). A sealing resin (SM) fills into the gap between the bottom substrate (100) and the top substrate (300) and sealing the logic die (50) and the plurality of copper cored solder balls (60) in the gap.

## Description

### Cross Reference to Related Applications

This application claims the benefit of U.S. Provisional Application No. 63/316,004, filed on March 3rd, 2022. The content of the application is incorporated herein by reference.

### Background

The present disclosure relates generally to the field of semiconductor packaging. More particularly, the present disclosure relates to a thermally enhanced semiconductor package having a thick logic die.

Package-on-Package (PoP) is an integrated circuit packaging method to combine vertically discrete logic and memory ball grid array (BGA) packages. Two or more packages are installed atop each other, i.e. stacked, with a standard interface to route signals between them. This allows higher component density in devices, such as mobile phones or digital cameras.

PoP solutions are commonly used in baseband and applications processors in mobile phones. High-end phones have seen the fastest adoption of PoP packaging to provide high I/O and performance requirements. The main advantage of stacked PoP is that devices can be separately fully tested before assembly.

With development of the semiconductor industry, many studies are being conducted to improve reliability and durability of the semiconductor packages. An improvement of the PoP structure to increase the efficiency of thermal dissipation, application processor (AP) performance, and number of interconnects becomes very important and imperative.

### Summary

It is one object of the present disclosure to provide an improved in order to solve the above-mentioned prior art deficiencies or shortcomings. A semiconductor package and a package on package according to the invention are defined in claims 1 and 12, respectively. The dependent claims define preferred embodiments thereof.

One aspect of the present disclosure provides a semiconductor package including a bottom substrate and a top substrate space apart from the bottom substrate such that the bottom substrate and the top substrate define a gap therebetween; a logic die mounted on a top surface of the bottom substrate, wherein the logic die has a thickness of 125-350 micrometers; a plurality of copper cored solder balls disposed between the bottom substrate and the top substrate around the logic die to electrically connect the bottom substrate with the top substrate; and a sealing resin filling in the gap between the bottom substrate and the top substrate and sealing the logic die and the plurality of copper cored solder balls in the gap.

Preferably, the logic die is mounted on the top surface of the bottom substrate in a flip-chip fashion.

Preferably, the logic die comprises an active front side and a passive rear side, and wherein, a plurality of input/output (I/O) pads is provided on the active front side.

Preferably, the logic die is electrically connected to the bottom substrate through a plurality of conductive elements formed on the plurality of I/O pads, respectively.

Preferably, underfill resin is disposed in a space between the logic die and the top surface of the bottom substrate, and wherein the conductive elements are surrounded by the underfill resin.

Preferably, the bottom substrate and the top substrate are printed wiring boards or package substrates.

Preferably, the gap has a gap height ranging between 160-450 micrometers.

Preferably, an aspect ratio of the plurality of copper cored solder balls ranges between 1.1-2.0.

Preferably, a ball pitch of the plurality of copper cored solder balls is 0.2-0.3 mm.

Preferably, external connection terminals are disposed on a bottom surface of the bottom substrate.

Another aspect of the present disclosure provides a package on package (PoP) including a semiconductor package as described above; and a memory package mounted on the semiconductor package.

Preferably, the memory package comprises a LPDDR DRAM package.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the invention and are incorporated in and constitute a part of this specification. The drawings illustrate embodiments of the invention and, together with the description, serve to explain the principles of the invention. In the drawings:
FIG. 1 is a schematic, cross-sectional diagram showing an exemplary semiconductor package having thick logic die in accordance with an embodiment of the invention; and
FIG. 2 is a schematic, cross-sectional diagram showing an exemplary package on package (PoP) having thick logic die in accordance with an embodiment of the invention.

### Detailed Description

In the following detailed description of embodiments of the invention, reference is made to the accompanying drawings, which form a part hereof, and in which is shown by way of illustration specific preferred embodiments in which the disclosure may be practiced.

These embodiments are described in sufficient detail to enable those skilled in the art to practice them, and it is to be understood that other embodiments may be utilized and that mechanical, chemical, electrical, and procedural changes may be made without departing from the scope of the present disclosure. The following detailed description is, therefore, not to be taken in a limiting sense, and the scope of embodiments of the present invention is defined only by the appended claims.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

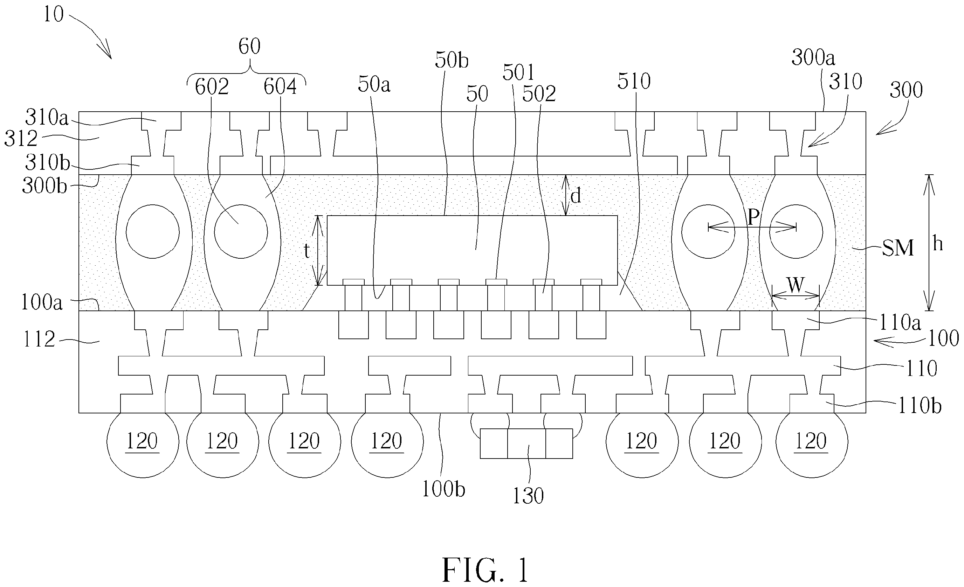

FIG. 1 is a schematic, cross-sectional diagram showing an exemplary semiconductor package having thick logic die in accordance with an embodiment of the invention. As shown in FIG. 1, the semiconductor package 10 comprises a bottom substrate 100 having a top surface 100a and an opposing bottom surface 100b. Preferably, the bottom substrate 100 may be a printed wiring board or a package substrate having a plurality of conductive interconnect structures 110 and at least an insulating layer 112. Preferably, for example, the conductive interconnect structures 110 may comprise a plurality of pad patterns 110a distributed on the top surface 100a and a plurality of pad patterns 110b distributed on the bottom surface 100b.

Preferably, a logic die 50 is mounted on the top surface 100a of the bottom substrate 100 in a flip-chip fashion. Preferably, for example, the logic die 50 may be an application processor die or a baseband processor die, but is not limited thereto. Preferably, for example, the logic die 50 has a thickness t ranging between 125-350 micrometers, for example, 170 micrometers, which is thicker than a normal logic die (about 80 µm thick) used in high-end mobile devices such as high-end mobile phones.

Preferably, for example, the logic die 50 has an active front side 50a and a passive rear side 50b. Preferably, for example, a plurality of input/output (I/O) pads 501 is provided on the active front side 50a. Preferably, for example, the logic die 50 is electrically connected to the bottom substrate 100 through a plurality of conductive elements 502 such as solder bumps, metal bumps or pillars, which are formed on the plurality of I/O pads 501, respectively. Preferably, underfill resin 510 may be injected into a space between the logic die 50 and the top surface 100a of the bottom substrate 100. Preferably, the conductive elements 502 are surrounded by the underfill resin 510.

Preferably, the logic die 50 is disposed between the bottom substrate 100 and a top substrate 300. Preferably, the top substrate 300 may be a printed wiring board or a package substrate having a plurality of conductive interconnect structures 310 and at least an insulating layer 312. Preferably, for example, the conductive interconnect structures 310 may comprise a plurality of pad patterns 310a distributed on the top surface 300a and a plurality of pad patterns 310b distributed on the bottom surface 300b. Preferably, a plurality of copper cored solder balls 60 or other more ductility metal connection is disposed on the pad patterns 310b distributed on the bottom surface 300b of the top substrate 300, respectively.

Preferably, the bottom substrate 100 is connected electrically with the top substrate 300 via the copper cored solder balls 60 around the logic die 50. The sealing resin SM is filled into a gap having a gap height h between the bottom substrate 100 and the top substrate 300. Preferably, for example, the gap height h may range between 160-450 micrometers in 0.2-0.3 mm ball pitch range, but is not limited thereto. Preferably, for example, the pad patterns 110a, on which the copper cored solder balls 60 are attached, have a width w ranging between 100-300 micrometers, but is not limited thereto. Preferably, for example, an aspect ratio of the copper cored solder ball 60 may range between 1.1-2.0, for example, 1.44. Preferably, for example, a ball pitch P of the copper cored solder balls 60 may be 0.2-0.3 mm.

Preferably, the sealing resin SM surrounds the copper cored solder balls 60 and covers the passive rear side 50b and sidewalls of the logic die 50. Preferably, the sealing resin SM is in direct contact with the bottom surface 300b of the top substrate 300, the side surface of the underfill resin 510 and the top surface 100a of the bottom substrate 100. The gap between the bottom substrate 100 and the top substrate 300 is sealed with the sealing resin SM. The distance d between the passive rear side 50b of the logic die 50 and the bottom surface 300b of the top substrate 300 may be equal to or greater than 30 micrometers.

Preferably, each of the copper cored solder balls 60 may comprise a copper core 602 having a diameter of about 10 micrometers, which is coated with a solder layer 604. The copper cored solder balls 60 join the bottom substrate 100 and the top substrate 300. Preferably, for example, the copper core 602 is formed of copper or copper alloys and shaped into a solid sphere. Preferably, for example, the top substrate 300 having the copper cored solder balls 60 may be mounted onto the top surface 100a of the bottom substrate 100 by using a thermal compression bonding (TCB) method.

Preferably, external connection terminals 120 such as solder balls or BGA balls are joined to the pad patterns 110b on the bottom surface 100b of the bottom substrate 100 for further connection with a mother board or a system board. Preferably, a surface mount device 130 such as a capacitor or a resistor may be mounted on the bottom surface 100b of the bottom substrate 100.

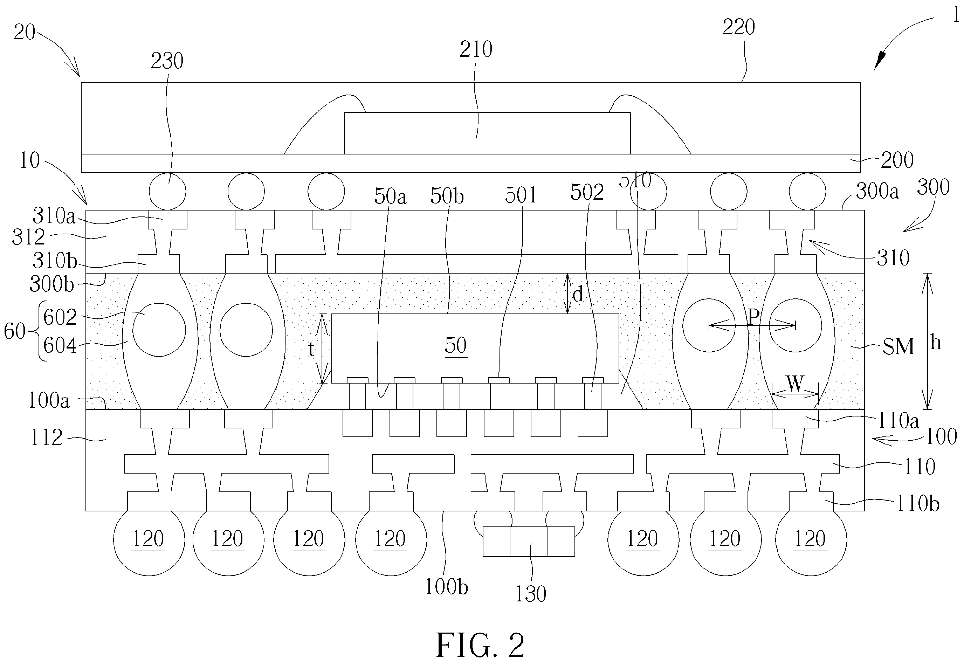

FIG. 2 is a schematic, cross-sectional diagram showing an exemplary package on package (PoP) having thick logic die in accordance with an embodiment of the invention, wherein like layers, regions or elements are designated by like numeral numbers or labels. As shown in FIG. 2, the PoP device 1 such as a high-bandwidth PoP (HBPoP) may comprise the semiconductor package 10 as set forth in FIG. 1 and a memory package 20 such as a LPDDR DRAM package stacked on the semiconductor package 10. Preferably, for example, the memory package 20 may comprise a substrate 200, a memory die 210 mounted on the substrate 200, and a molding compound 220 encapsulating the memory die 210. Preferably, for example, the memory package 20 may be electrically connected to the semiconductor package 10 through a plurality of conductive elements 230 such as solder balls or bumps.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A semiconductor package (10), comprising:
a bottom substrate (100) and a top substrate (300) space apart from the bottom substrate (100) such that the bottom substrate (100) and the top substrate (300) define a gap therebetween;
a logic die (50) mounted on a top surface (100a) of the bottom substrate (100), wherein the logic die (50) has a thickness of 125-350 micrometers;
a plurality of copper cored solder balls (60) disposed between the bottom substrate (100) and the top substrate (300) around the logic die (50) to electrically connect the bottom substrate (100) with the top substrate (300); and
a sealing resin filling (SM) in the gap between the bottom substrate (100) and the top substrate (300) and sealing the logic die (50) and the plurality of copper cored solder balls (60) in the gap.

2. The semiconductor package (10) according to claim 1, wherein the logic die (50) is mounted on the top surface (100a) of the bottom substrate (100) in a flip-chip fashion.

3. The semiconductor package (10) according to claim 1 or 2, wherein the logic die (50) comprises an active front side (50a) and a passive rear side (50b), and wherein, a plurality of input/output, in the following also referred to as I/O, pads (501) is provided on the active front side (50a).

4. The semiconductor package (10) according to any one of claims 1 to 3, wherein the logic die (50) is electrically connected to the bottom substrate (100) through a plurality of conductive elements (502) formed on the plurality of I/O pads (501), respectively.

5. The semiconductor package (10) according to any one of claims 1 to 4, wherein underfill resin (510) is disposed in a space between the logic die (50) and the top surface (100a) of the bottom substrate (100), and wherein the conductive elements (502) are surrounded by the underfill resin (510).

6. The semiconductor package (10) according to any one of claims 1 to 5, wherein the bottom substrate (100) and the top substrate (300) are printed wiring boards or package substrates.

7. The semiconductor package (10) according to any one of claims 1 to 6, wherein the gap has a gap height (h) ranging between 160-450 micrometers.

8. The semiconductor package (10) according to any one of claims 1 to 7, wherein an aspect ratio of the plurality of copper cored solder balls (60) ranges between 1.1-2.0.

9. The semiconductor package (10) according to any one of claims 1 to 8, wherein a ball pitch (P) of the plurality of copper cored solder balls (60) is 0.2-0.3 mm.

10. The semiconductor package (10) according to any one of claims 1 to 9, wherein each of the plurality of copper cored solder balls (60) comprises a copper core (602) coated with a solder layer (604).

11. The semiconductor package (10) according to any one of claims 1 to 10, wherein external connection terminals (120) are disposed on a bottom surface (100b) of the bottom substrate (100).

12. A package on package (1), comprising:
a semiconductor package (10) according to any one of claims 1 to 11; and
a memory package (20) mounted on the semiconductor package (10).

13. The package on package (1) according to claim 12, wherein the memory package (20) comprises a LPDDR DRAM package.
